# FASCICULE DE BREVET EUROPEEN

(11) **EP 0 787 974 B1**
(45) Date de publication et mention de la délivrance du brevet: **07.03.2001**
(21) Numéro de dépôt: 97400089.5
(22) Date de dépôt: 16.01.1997
(51) Int. Cl.: G01D 11/24, G01V 8/12, H03K 17/94

(54) **Détecteur photoélectrique étanche**
Abgedichteter fotoelektrischer Sensor
Sealed photoelectric sensor

(30) Priorité: 05.02.1996 FR 9601468
(43) Date de publication de la demande: 06.08.1997
(73) Titulaire: Schneider Electric Industries SA, 92500 Rueil-Malmaison (FR)
(72) Inventeur: Maurin, Jacques, 16590 Brie (FR)
(74) Mandataire: Carias, Alain

(56) Documents cités:
- DE-U- 9 213 774
- FR-A- 2 385 268
- GB-A- 2 056 660

## Description

La présente invention concerne un détecteur photoélectrique comprenant dans un boîtier un circuit électronique sur un bord duquel est fixé au moins un composant optique émetteur ou récepteur d'axe optique déterminé.

De tels détecteurs sont bien connus, par exemple d'après le document FR-2385 268 qui comprennent un circuit imprimé et un composant optoélectronique émetteur et un composant optoélectronique récepteur soudés au circuit imprimé, ainsi qu'un support de centrage de ces deux composants, lequel support est doté d'une surface externe tubulaire pour se loger dans le boîtier et d'au moins un logement interne de forme générale cylindrique ou cylindro-conique dans lequel sont positionnés les composants.

Pour produire une collimation du faisceau émis par le détecteur et du faisceau réfléchi par la cible ou la mire, il est généralement prévu de monter une pièce optique comprenant des lentilles ; cette pièce optique présente une paroi frontale dotée de lentilles centrées sur les axes optiques des composants et peut être montée devant le support de centrage ou'peut envelopper celui-ci au moyen d'une paroi tubulaire. Lorsqu'elle est tubulaire,la pièce optique est elle-même assemblée à un boîtier tubulaire qui forme l'enveloppe extérieure du détecteur ; cet assemblage a lieu par butée d'un rebord de la pièce optique contre le bord d'une extrémité ouverte du boîtier tubulaire.

D'autre part, on sait que, au cours de la fabrication du détecteur, l'intérieur du boîtier est rempli de résine durcissable de manière à rendre le détecteur moins sensible aux altérations dues à son environnement, notamment aux chocs et aux vibrations. Comme il subsiste toujours dans le boîtier des discontinuités de remplissage, il est souhaitable d'assurer une bonne étanchéité du volume intérieur du boîtier vis-à-vis de l'extérieur. A cet effet, il est connu de disposer un joint d'étanchéité dans un dégagement du support des composants optiques ou de la pièce optique tubulaire pour rendre étanche sa liaison avec la pièce voisine du détecteur ou de fixer ces éléments entre eux ou au boîtier par collage.

La présente invention a pour but d'assurer dans un détecteur photoélectrique du type décrit une étanchéité satisfaisante par des dispositions plus simples.

Elle concerne un détecteur photoélectrique comprenant dans un boîtier un circuit électronique sur un bord duquel est fixé au moins un composant optique émetteur ou récepteur d'axe optique déterminé, et un ensemble optique comportant d'une part un support de centrage du composant, lequel support est doté d'au moins un logement interne pour le composant, et d'autre part une pièce optique comprenant une paroi tubulaire qui entoure le support et une paroi frontale dotée d'au moins une lentille centrée sur l'axe optique du composant.

Selon l'invention, le support de centrage du composant est une pièce moulée en élastomère comportant sur sa surface externe une collerette souple d'étanchéité venue de moulage et applicable contre la surface interne de la paroi tubulaire de la pièce optique. La pièce en élastomère est de préférence ajustée sans colle ni joint par son élasticité propre sur le ou les composants optiques.

Il résulte de la souplesse du support de centrage des composants et de la présence de sa collerette tant un arrêt du flux de résine entre le support des composants et la pièce optique lors de la fabrication du boîtier qu'un barrage à la pénétration d'eau ou d'humidité vers l'intérieur du boîtier lors de l'utilisation du détecteur.

La description qui suit d'un exemple de réalisation de l'invention, en regard des dessins annexés, explicite les avantages et résultats obtenus.

La figure 1 représente en élévation latérale un détecteur photoélectrique selon l'invention.

La figure 2 est une vue de face du détecteur de la figure 1.

La figure 3 montre à plus grande échelle la partie avant du détecteur de la figure 1.

Le détecteur photoélectrique illustré sur les figures comporte un boîtier 10 en matière plastique ou métallique fileté extérieurement en 11 pour être monté dans un organe porteur taraudé. Le boîtier 10 a une forme cylindrique ou prismatique et il est clos vers l'avant par une pièce optique transparente 20 qui sera décrite plus loin et vers l'arrière par un bouchon 12 qui est muni d'un joint d'étanchéité 12a et qui permet le passage d'un câble de raccordement 13. Dans le volume intérieur 14 du boîtier est logé un circuit électronique implémenté au moyen d'un circuit imprimé 15 qui est connecté à l'arrière au câble 13 et à l'avant à deux composants optiques, à savoir un composant optique émetteur 16 et un composant optique récepteur 17 présentant des axes optiques X1 et X2 parallèles ou sensiblement parallèles à un axe X ; cet axe X se trouve être ici l'axe longitudinal du boîtier cylindrique.

Un ensemble optique est disposé à l'avant du détecteur ; il se compose de la pièce optique 20 et d'un support 30 de centrage du composant. Le support 30 est placé dans le volume 14 et vers l'avant pour loger les composants 16,17 et servir ainsi à bien définir la direction de leurs axes optiques X1,X2. Le support de centrage 30 comprend un corps tubulaire 31, cylindrique dans le présent exemple, mais qui pourrait être prismatique, et deux logements internes 32,33 où sont positionnés de manière étanche les composants 16,17. Les logements 32,33 débouchent vers l'avant du support via des ouvertures de forme générale évasée 34,35 séparées par une paroi 36.

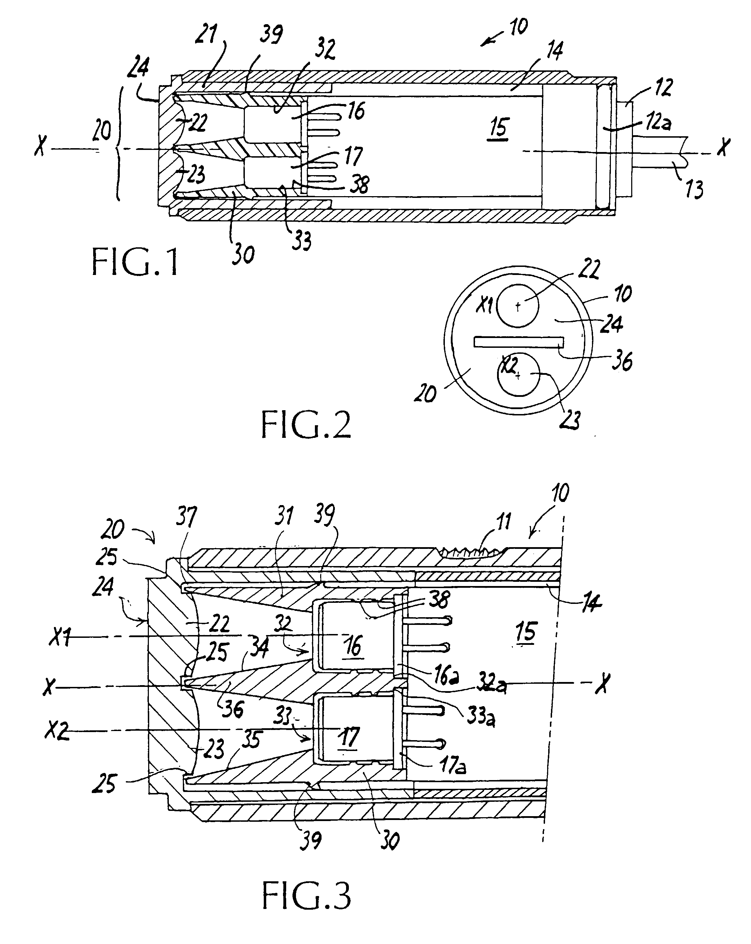

La pièce optique 20 est dans cet exemple une pièce cylindrique en polycarbonate ou en polyméthacrylate de méthyle et comprend d'une part une paroi tubulaire 21 qui entoure le corps 31 du support 30 et d'autre part une paroi frontale 24 munie de deux lentilles 22,23 respectivement associées aux composants 16,17. La pièce optique est engagée et mise en butée sur le support 30 au moyen d'évidements appropriés 25 coopérant avec des éléments de butée frontaux du support, à savoir un bord antérieur 37 du support, prolongeant son enveloppe 31, et un bord antérieur de sa paroi centrale 36 (voir figure 3).

Selon l'invention, le support de centrage 30 présente d'une part dans ses logements internes de positionnement 32,33 des surfaces internes assurant par ajustement élastique le centrage et l'étanchéité des composants 16,17, avec éventuellement présence de nervures ou d'autres éléments analogues 38 venus de moulage; le support présente d'autre part sur la surface externe de son corps tubulaire 31 une collerette circulaire souple 39 d'étanchéité appliquée contre la surface interne 26 de la paroi tubulaire 21. Le terme collerette désigne ici tout élément de forme annulaire prévu à l'extérieur du corps 31. Le support 30 est avantageusement une pièce en élastomère venue de moulage avec les éléments de centrage et d'étanchéité 38 et la collerette souple 39. On notera que les collerettes rigides 16a,17a des composants optiques 16,17 sont mises en butée sur des épaulements 32a,33a du support 30.

A l'assemblage, après engagement des composants émetteur 16 et récepteur 17 dans le support et leur soudage au circuit imprimé 15, l'ensemble composé de la pièce optique 20 et du support de centrage 30 équipé des composants et lié au circuit imprimé est introduit dans le volume intérieur 14 du boîtier 10, jusqu'à butée du rebord 27 de la pièce optique 20 contre le bord antérieur du boîtier. Le remplissage de résine qui est ensuite effectué à partir de l'arrière dans le volume intérieur 14 du boîtier permet de noyer le circuit électronique et de fixer d'une part le support 30 à la pièce optique 20, d'autre part la pièce optique 20 au boîtier 10 ; la présence de la collerette en élastomère 39 et l'ajustement élastique des logements 32,33 et/ou de leurs nervures ou éléments analogues 38 sur les composants arrêtent l'excès de flux de résine risquant d'aller vers les ouvertures 34,35. D'autre part, la pénétration d'eau vers les ouvertures 34,35 est également empêchée par la collerette 39 et les moyens d'ajustement tels que les éléments 38.

## Revendications

1. Détecteur photoélectrique comprenant dans un boîtier :
- un circuit électronique (15) sur un bord duquel est fixé au moins un composant optique émetteur ou récepteur (16,17) d'axe optique déterminé,
- un ensemble optique comportant d'une part un support de centrage (30) du composant, lequel support est doté d'au moins un logement interne (32,33) dans lequel se positionne un composant, et d'autre part une pièce optique (20) comprenant une paroi frontale dotée d'au moins une lentille (22,23) centrée sur l'axe optique (X1,X2) du composant,
- le boîtier (10) enveloppant le circuit électronique et l'ensemble optique (20,30), ce dernier étant introduit dans le boîtier avec butée d'un rebord de la pièce optique contre un bord antérieur du boîtier,
caractérisé par le fait que :
le support (30) de centrage du composant (16,17) est une pièce moulée en élastomère logée dans une paroi tubulaire (21) de la pièce optique et présentant sur sa surface externe une collerette souple (39) d'étanchéité venue de moulage et appliquée contre la surface interne (26) de la paroi tubulaire (21) de la pièce optique (20).

2. Détecteur photoélectrique selon la revendication 1, caractérisé par le fait que la pièce optique (20) est appliquée d'une part sur des éléments de butée frontaux (36,37) du support de centrage (30) et d'autre part sur le bord antérieur du boîtier.

3. Détecteur photoélectrique selon la revendication 1, caractérisé par le fait que le composant optique (16,17) est ajusté et maintenu élastiquement dans le logement correspondant (32,33) du support par l'élasticité propre de la surface interne du logement.

4. Détecteur photoélectrique selon la revendication 1, caractérisé par le fait que le support de centrage présente dans son logement de positionnement (32,33) au moins un élément de forme (38) venu de moulage pour le centrage élastique et l'étanchéité du composant.

## Patentansprüche

1. Photozellendetektor, der in einem Gehäuse enthält:
- einen elektronischen Kreis (15) an dessen Kante zumindest eine optische Komponente Sender oder Empfänger (16,17) mit einer bestimmten, optischen Achse befestigt ist,
- einen optischen Satz mit einerseits einem Zentrierungsträger (30) der Komponente, wobei dieser Träger mit zumindest einem inneren Lager (32,33) ausgestattet ist, in welchem sich eine Komponente positioniert und andererseits ein optisches Teil (20) mit einer vorderen Wand, die mit mindestens einer Linse (22,23) ausgestattet ist, welche auf die optische Achse (X1,X2) der Komponente zentriert ist,
- das Gehäuse (10), das einen elektronischen Kreis und den optischen Satz (20,30) umhüllt, wobei dieser letztere in das Gehäuse mit Anschlag am Ansatz des optischen Teils gegen die vordere Kante des Gehäuses eingeführt wird,
dadurch gekennzeichnet daß:
der Zentrierungsträger (30) der Komponente (16,17) ein aus Elastomer geformtes Teil ist, das in eine röhrenförmige Wand (21) des optischen Teils eingesetzt ist und auf seiner Außenseite einen flexiblen Dichtungsflansch (39) aufweist, der vom Formen kommt und gegen die innere Fläche (26) der röhrenförmigen Wand (21) des optischen Teils (20) aufliegt.

2. Photozellendetektor nach dem Anspruch 1, dadurch gekennzeichnet, daß das optische Teil (20) einerseits auf frontale Anschlagelemente (36,37) des Zentrierungsträgers (30) und andererseits auf die vordere Kante des Gehäuses angesetzt wird.

3. Photozellendetektor nach dem Anspruch 1, dadurch gekennzeichnet, daß die optische Komponente (16,17) elastisch am entsprechenden Lager (32,33) des Trägers durch die eigene Elastizität der inneren Fläche des Lagers angepaßt und festgehalten wird.

4. Photozellendetektor nach dem Anspruch 1, dadurch gekennzeichnet, daß der Zentrierungsträger in seinem Positionierungslager (32,33) zumindest ein Formelement (38) für das flexible Zentrieren und die Dichtigkeit der Komponente aufweist, das vom Formen kommt.

## Claims

1. Photoelectric detector comprising in a casing:
- an electronic circuit (15) on one edge of which is fixed at least one transmitter or receiver optical component (16,17) of determined optical axis,
- an optical unit including firstly a centering support (30) of the component, which said support is equipped with at least one internal housing (32,33) in which the component is housed, and secondly an optical part (20) comprising a frontal wall equipped with at least one lens (22,23) centered on the optical axis (X1, X2) of the component,
- the casing (10) enveloping the electronic circuit and the optical unit (20,30), the latter being introduced in the casing by stopping a rim of the optical part against a front edge of the casing,
characterized in that:
the centering support (30) of the component (16,17) is a part molded in elastomer housed in a tubular wall (21) of the optical part and having on its external surface a flexible sealing flange (39) created by molding and applied against the internal surface (26) of the tubular wall (21) of the optical part (20).

2. Photoelectric detector according to claim 1, characterized in that the optical part (20) is applied firstly on frontal stopping elements (36,37) of the centering support (30) and secondly on the front edge (18) of the casing.

3. Photoelectric detector according to claim 1, characterized in that the optical component (16,17) is adjusted and maintained resiliently in the corresponding housing (32,33) of the support by the housing internal surface's own resilience.

4. Photoelectric detector according to claim 1, characterized in that the centering support presents, in its positioning housing (32,33), at least one mold-formed element (38) for the resilient centering and the sealing of the component.
